# EUROPEAN PATENT APPLICATION

(11) **EP 1 453 210 A1**
(43) Date of publication of application: **01.09.2004**
(21) Application number: 03723250.1
(22) Date of filing: 08.05.2003
(51) Int. Cl.: H04B 1/04, H04B 7/26, H04J 13/00, H04L 27/00

(54) **RADIO TRANSMISSION DEVICE AND RADIO TRANSMISSION METHOD**

(30) Priority: 10.05.2002 JP 2002135961
(71) Applicant: MATSUSHITA ELECTRIC INDUSTRIAL CO., LTD., Kadoma-shi, Osaka 571-8501 (JP)
(72) Inventor: AIZAWA, Junichi, Yokohama-shi, Kanagawa 240-0033 (JP); ITAHARA, Hiroshi, Yokohama-shi, Kanagawa 226-0025 (JP); HAGIWARA, Yuichi, Yokohama-shi, Kanagawa 233-0002 (JP)
(74) Representative: Grünecker, Kinkeldey, Stockmair & Schwanhäusser Anwaltssozietät
(86) International application number: PCT/JP2003/005738
(87) International publication number: WO 2003/096557

(57) **Abstract**

A power calculation section (105) calculates the power of a transmit signal that has passed through transmit frame generation sections (101a through 101c), modulation sections (102a through 102c), spreading sections (103a through 103c), and a multiplexing section (104). A burst signal detection section (106) detects a burst signal fromthispower. Againcalculationsection (107) outputs fixed gain when a burst signal is detected. An attenuation amount calculation section (108) calculates an attenuation amount based on the gain calculated by the gain calculation section (107). The transmit signal is subjected to multiplication by the aforementioned gain in a gain multiplication section (109), predetermined radio processing in a transmitting radio section (110), and attenuation processing in accordance with the aforementioned attenuation amount in an attenuation section (111), and is transmitted from an antenna (112). By this means, it is possible to suppress excessive gain switching operations, and suppress modulation precision degradation and adjacent channel leakage power ratio degradation.

## Description

### Technical Field

The present invention relates to a radio transmitting apparatus and radio transmitting method in a radio communication system.

### Background Art

A conventional radio transmitting apparatus modulates, spreads, multiplexes, and performs gain adjustment on transmit data, executes predetermined radio processing such as D/A conversion, the performs attenuation and radio transmission from an antenna.

However, with a conventional apparatus, when the transmit signal is a burst signal such as a PDSCH (Physical Downlink Shared Channel) signal, transmit signal power fluctuation occurs frequently, and there are large fluctuations in the amount of gain adjustment prior to executing radio processing. A problem at this time is that instantaneous interruption of the transmit signal associated with gain switching frequently occurs, modulation precision is degraded, and the adjacent channel leakage power ratio is degraded.

### Disclosure of Invention

It is an object of the present invention to suppress excessive gain switching operations associated with transmit digital signal power fluctuation, and suppress modulation precision degradation and adjacent channel leakage power ratio degradation.

This object is achieved by means of a radio transmitting apparatus that fixes the gain to be multiplied by a transmit signal prior to execution of radio processing at a given value when transmit digital signal power enters a fluctuating state due to the transmission of a burst signal such as a PDSCH signal.

### Brief Description of Drawings

FIG.1 is a block diagram showing an example of the configuration of a radio transmitting apparatus according to Embodiment 1 of the present invention;
FIG.2A is a drawing for explaining transmit signal power fluctuation and attenuation amount switching;
FIG.2B is a drawing for explaining transmit signal power fluctuation and attenuation amount switching;
FIG.3 is a block diagram showing an example of the configuration of a radio transmitting apparatus according to Embodiment 2 of the present invention;
FIG.4 is a block diagram showing an example of the configuration of a radio transmitting apparatus according to Embodiment 3 of the present invention; and
FIG. 5 is a drawing for explaining the ef fect produced on transmit signal power by IIR filter processing.

### Best Mode for Carrying out the Invention

With reference now to the accompanying drawings, embodiments of the present invention will be explained in detail below.

### (Embodiment 1)

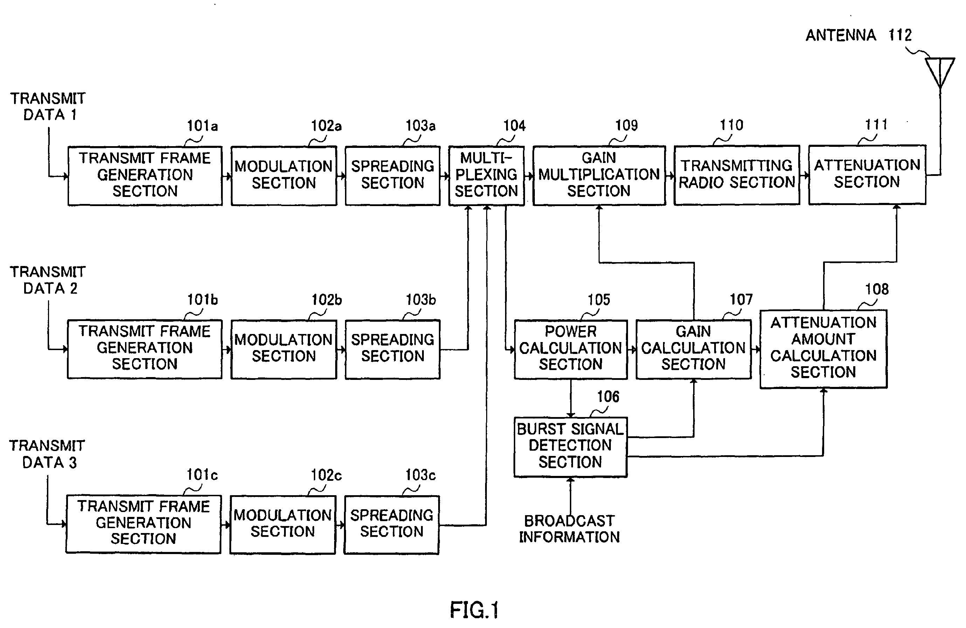

FIG.1 is a block diagram showing an example of the configuration of a radio transmitting apparatus according to Embodiment 1 of the present invention. Here, by way of example, a case is described in which a CDMA (Code Division Multiple Access) radio transmitting apparatus is installed in a base station apparatus.

In FIG.1, transmit frame generation sections 101a, 101b, and 101c generate transmit frames from transmit data 1, transmit data 2, and transmit data 3. Modulation sections 102a, 102b, and 102c perform modulation processing on the generated transmit signals and generate modulated signals. Spreading sections 103a, 103b, and 103c perform spreading processing on these modulated signals. A multiplexing section 104 multiplexes the spread modulated signals output by spreading sections 103a, 103b, and 103c.

Apower calculation section 105 calculates the power of the multiplex signal output from multiplexing section 104. Aburst signal detection section 106 detects whether or not the transmit signal is a burst signal from fluctuation of the calculated signal power value, and outputs the detection result to a gain calculation section 107 and attenuation amount calculation section 108.

Gain calculation section 107 calculates gain to be multiplied by the transmit signal based on the detection result reported from burst signal detection section 106 and the signal power calculated by power calculation section 105, and outputs this calculated gain to a gain multiplication section 109 and attenuation amount calculation section 108.

Attenuation amount calculation section 108 calculates an attenuation amount based on the detection result reported from burst signal detection section 106 and the gain calculated by gain calculation section 107, and outputs this calculated attenuation amount to an attenuation section 111.

Gain multiplication section 109 multiplies the multiplex signal output from multiplexing section 104 by the gain calculated by gain calculation section 107. A transmitting radio section 110 executes predetermined radio processing such as orthogonal modulation on the signal after gain multiplication. Attenuation section 111 attenuates the signal output from transmitting radio section 110, using the attenuation amount calculated by attenuation amount calculation section 108. An antenna 112 transmits this radio signal.

Power amplification and power attenuation operations of the radio transmitting apparatus that has the above configuration will now be described in detail.

A feature of the present invention is that the gain by which multiplication is performed by gain multiplication section 109 and the attenuation amount used by attenuation section 111 differ according to whether a burst signal is detected or not detected by burst signal detection section 106. In other words, a feature of the present invention is that when a burst signal is detected, the gain by which multiplication is performed by gain multiplication section 109 and the attenuation amount used by attenuation section 111 are made fixed values.

Burst signal detection section 106 counts the number of times power fluctuation occurs in a certain fixed observation period for the power calculated by power calculation section 105, and indirectly counts the number of times a situation arises in which the attenuation amount is switched by attenuation section 111 in line with power fluctuation. Then, if this number of switching times is greater than or equal to a preset threshold value, burst signal detection section 106 determines that the transmit signal is a burst signal, and outputs a detection result to the effect that a burst signal has been detected to gain calculation section 107 and attenuation amount calculation section 108. On the other hand, if the number of switching times is less than the preset threshold value, burst signal detection section 106 determines that the transmit signal is not a burst signal, and outputs a detection result to the effect that a burst signal has not been detected to gain calculation section 107 and attenuation amount calculation section 108.

First, operation will be described for the case where burst signal detection section 106 determines that the transmit signal is not a burst signal.

Gain calculation section 107 calculates gain whereby the power of the signal input to transmitting radio section 110 is kept within a fixed range, based on the power calculated by power calculation section 105, and outputs this calculated gain to gain multiplication section 109 and attenuation amount calculation section 108.

Gain multiplication section 109 multiplies the multiplex signal output from multiplexing section 104 by the gain calculated by gain calculation section 107, amplifies the power, and outputs the resulting signal to transmitting radio section 110.

Attenuation amount calculation section 108 calculates an attenuation amount corresponding to the gain calculated by gain calculation section 107, and outputs this calculated attenuation amount to attenuation section 111. For example, if the gain calculated by gain calculation section 107 is 10 dB, the attenuation amount will also be 10 dB.

Attenuation section 111 attenuates the signal output from transmitting radio section 110 using the attenuation amount calculated by attenuation amount calculation section 108, and transmits the resulting signal from antenna 112.

When a burst signal is not detected, according to the above configuration, gain that is in accordance with the power calculated by power calculation section 105 is used, and gain adjustment is performed before executing radio processing, enabling the dynamic range of transmitting radio section 110 to be used efficiently.

Next, operation will be described for the case where burst signal detection section 106 determines that the transmit signal is a burst signal.

On receiving a detection result from burst signal detection section 106 to the effect that a burst signal has been detected, gain calculation section 107 outputs fixed gain to gain multiplication section 109 and attenuation amount calculation section 108.

For example, as fixed gain, the lowest gain may be selected from a plurality of gain values calculated by gain calculation section 107 in line with power fluctuation within the above-described power fluctuation observation period. When gain values of 10 dB, 12 dB, and 15 dB are calculated, the fixed gain will be the lowest value of 10 dB. By this means it is possible to prevent gain from being set excessively high, and excessive input to transmitting radio section 110 can be prevented.

Also, when it is known beforehand by means of broadcast information that there is no power fluctuation, burst signal detection section 106 stops burst signal detection. By this means, erroneous detection of a burst signal can be prevented with certainty.

The operation of attenuation amount calculation section 108, gain multiplication section 109, and attenuation section 111 is the same as in the case where burst signal detection section 106 determines that the transmit signal is not a burst signal, as described above.

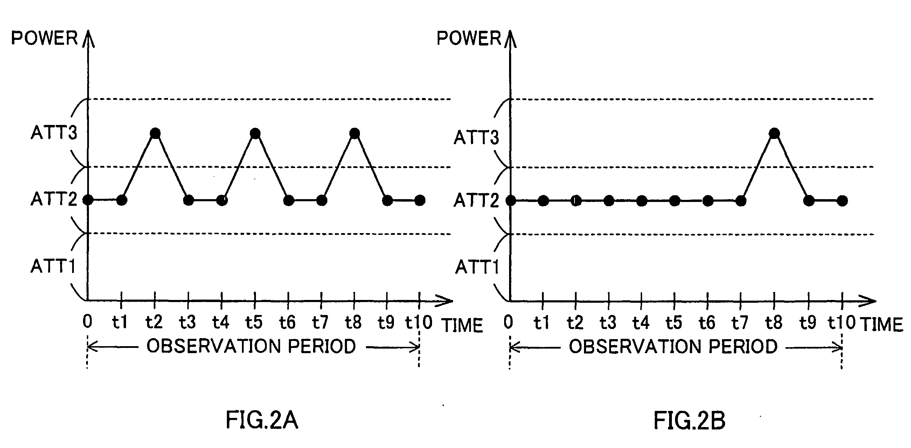

FIG.2A and FIG.2B are drawings showing transmit signal power fluctuation and attenuation amount switching. Here, a solid line indicates transmit signal power, and dotted lines indicate attenuation switching thresholds when attenuation amounts are designated ATT1, ATT2, and ATT3.

In gain calculation section 107, gain is determined according to the transmit signal power value calculated by power calculation section 105. Together with this, in attenuation amount calculation section 108, an attenuation amount is calculated according to the gain output from gain calculation section 107. For example, in FIG.2A, the power value at time t1 is in the range of attenuation amount ATT2, and therefore the attenuation amount is calculated as ATT2, while at time t2 the power value is in the range of attenuation amount ATT3, and therefore the attenuation amount is calculated as ATT3.

Let us assume, for example, that the threshold value for the number of switching times preset in burst signal detection section 106 is 4. In this case, in FIG.2A, switching from ATT2 to ATT3, or switching from ATT3 to ATT2, occurs a total of 6 times during the observation period (0 to t10). Therefore, in this case, since the number of switchovers exceeds the threshold number of 4, a detection result to the effect that a burst signal has been detected is output to gain calculation section 107 and attenuation amount calculation section 108 from burst signal detection section 106 at the point at which observation ends (t10).

In FIG.2B, switching from ATT2 to ATT3, or switching from ATT3 to ATT2, occurs a total of twice during the observation period. Therefore, in this case, since the number of switchovers is less than the threshold number of 4, a detection result to the effect that a burst signal has not been detected is output to gain calculation section 107 and attenuation amount calculation section 108 from burst signal detection section 106 at the point at which observation ends (t10).

According to the above configuration, transmit signal power values are observed over a predetermined period in order that gain is not adjusted in reaction to a transitory power fluctuation, thereby enabling a burst signal to be detected with good precision.

In burst signal detection, it is also possible to detect that the transmit signal is a burst signal at the instant at which the number of attenuation amount switchovers due to signal power fluctuation exceeds a predetermined threshold. In this case, for example, in FIG. 2A a detection result to the effect that a burst signal has been detected is output to gain calculation section 107 and attenuation amount calculation section 108 from burst signal detection section 106 at the instant at which the number of power fluctuations reaches the threshold value of 4 - that is, at point t6. By this means, the fact that power is in a fluctuating state is determined promptly at the point at which the number of transmit signal power value fluctuations becomes greater than or equal to the threshold value, thereby enabling detection in which even momentary power fluctuations are tracked.

It is also possible to determine that the transmit signal is not a burst signal if, after a burst signal is detected, the attenuation amount due to signal power fluctuation is not switched consecutively for a predetermined number of times - that is to say, if the attenuation amount is not switched for a given period. For example, in FIG.2B, let us assume that it is to be determined that the transmit signal is not a burst signal if the attenuation amount is not switched consecutively 6 times. In this case, a detection result to the effect that a burst signal has not been detected is output to gain calculation section 107 and attenuation amount calculation section 108 from burst signal detection section 106 at point t5. By this means, the fact that the transmit signal is not a burst signal can be detected instantaneously when a burst signal ceases to be transmitted.

Thus, according to this embodiment, the fact that transmit digital signal power enters a fluctuating state is determined by means of various determination methods, gain is fixed at a given value when amplifying a transmit signal prior to executing radio processing, and the attenuation amount is fixed at a given value when a transmit signal is attenuated after radio processing has been executed, thereby enabling excessive gain switching operations to be suppressed, and enabling modulation precision degradation and adjacent channel leakage power ratio degradation to be suppressed.

A case has here been described, by way of example, in which three transmit data are multiplexed and transmitted, but the number of multiplexed transmit data is not limited to this, and may be four or more.

Also, a case has here been described, by way of example, in which a burst signal detection result is output to gain calculation section 107 and attenuation amount calculation section 108, but if it is so arranged that attenuation amount calculation section 108 always uses the reciprocal of the gain detected by gain calculation section 107, the burst signal detection result may be output only to gain calculation section 107.

Moreover, a case has here been described, by way of example, in which burst signal detection is determined according to the number of times the attenuation amount is switched, but burst signal detection may also be determined according to the number of times gain is switched.

### (Embodiment 2)

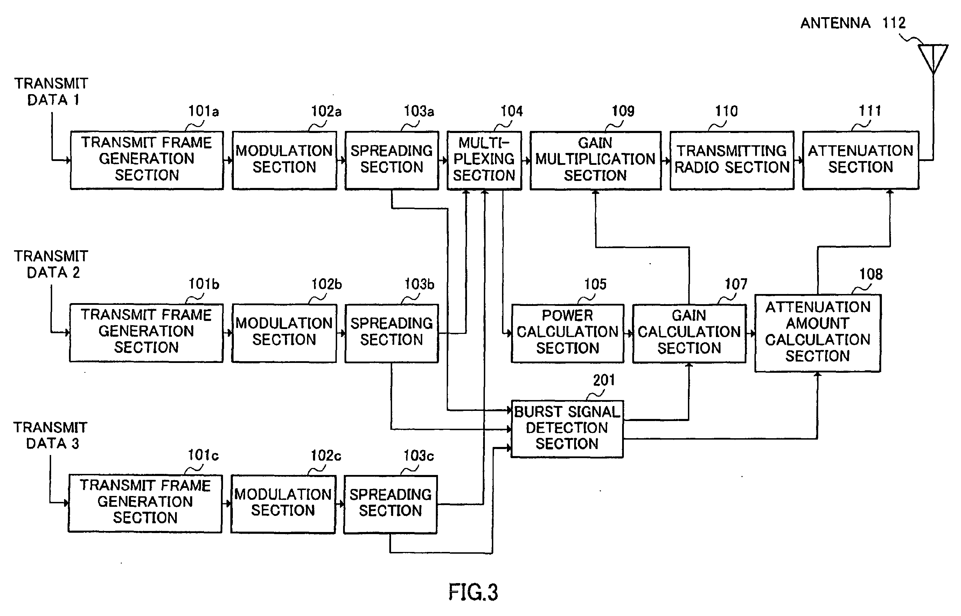

FIG.3 is a block diagram showing an example of the configuration of a radio transmitting apparatus according to Embodiment 2 of the present invention. This radio transmitting apparatus has the same basic configuration as the radio transmitting apparatus shown in FIG.1, and therefore configuration elements identical to those in FIG.1 are assigned the same codes as in FIG.1 and descriptions thereof are omitted.

A feature of this embodiment is that burst signal detection is performed from a spread modulated signal.

In FIG.3, spreading sections 103a, 103b, and 103c perform spread modulation processingon modulated signals, output the resulting signals to multiplexing section 104, and at the same time output transmit data transmission power settings to a burst signal detection section 201.

Burst signal detection section 201 observes signal power fluctuation from the transmission power settings output from spreading sections 103a, 103b, and 103c, and detect whether or not the transmit signal is a burst signal. Operation after a burst signal is detected is the same as in Embodiment 1.

By this means, it is determined directly from a transmit signal prior to transmission power measurement whether or not the signal is associated with power fluctuation, thereby enabling power fluctuation to be measured more accurately. Also, since determination is possible without waiting for power measurement, power fluctuation determination can be carried out rapidly, especially in cases where totalization time is necessary for power measurement.

### (Embodiment 3)

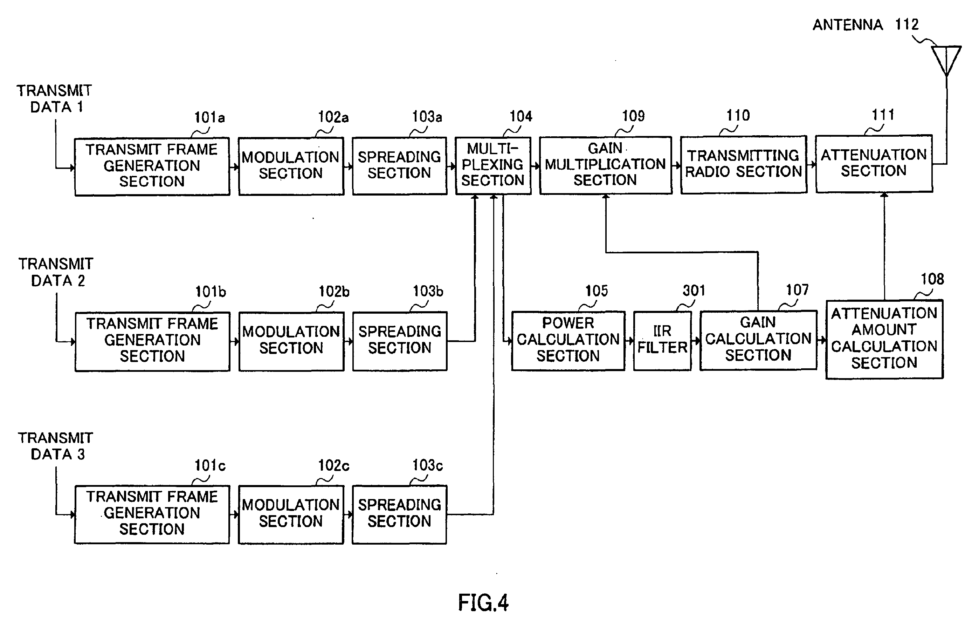

FIG.4 is a block diagram showing an example of the configuration of a radio transmitting apparatus according to Embodiment 3 of the present invention. This radio transmitting apparatus has the same basic configuration as the radio transmitting apparatus shown in FIG.1, and therefore configuration elements identical to those in FIG.1 are assigned the same codes as in FIG.1 and descriptions thereof are omitted.

A feature of this embodiment is that an IIR (Infinite Impulse Response) filter is provided instead of a burst signal detection section.

In FIG.4, IIR filter 301 executes IIR filter processing on signal power calculated by power calculation section 105, and outputs the result to gain calculation section 107. Subsequent processing is the same as in Embodiment 1.

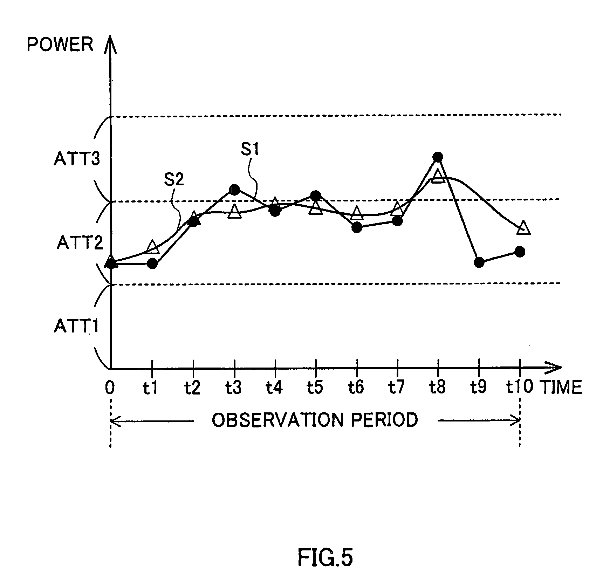

FIG. 5 is a drawing for explaining the effect produced on transmit signal power by IIR filter processing. Transmit signal S1 input to IIR filter 301 becomes signal S2 after IIR filter processing. The meaning of the dotted lines is the same as in FIG.2.

By traversing IIR filter 301, the transmit signal is smoothed. It can be seen, for example, that transmit signal power decreases at t3 and t5, falling below the ATT2 and ATT3 switching thresholds.

It can be seen that, as a result, even in cases where attenuation amount switching occurs if gain calculation is performed using a transmit signal prior to execution of IIR filter processing, attenuation amount switching does not occur if a signal following IIR filter processing is used.

Thus, according to this embodiment, excessive fluctuation of signal power is suppressed by means of IIR filter processing instead of by fixing gain at a given value when a burst signal is detected. Consequently, excessive gain switching operations can be suppressed, and modulation precision degradation and adjacent channel leakage power ratio degradation can be suppressed.

This embodiment can also be implemented in combination with Embodiment 1 or Embodiment 2.

A radio transmitting apparatus according to the present invention can be installed in a communication terminal apparatus, by which means it is possible to provide a communication terminal apparatus that has the same kind of effects as described above.

A case has here been described, by way of example, in which a radio transmitting apparatus according to the present invention employs a CDMA method, but use in another mobile communication system is also possible.

As described above, according to the present invention, it is possible to suppress excessive gain switching operations associated with transmit digital signal power fluctuation, and suppress modulation precision degradation and adjacent channel leakage power ratio degradation.

This application is based on Japanese Patent Application No.2002-135961 filed on May 10, 2002, entire content of which is expressly incorporated by reference herein.

### Industrial Applicability

The present invention is applicable to a base station apparatus of a mobile communication system employing a CDMA method, etc.

## Claims

1. A radio transmitting apparatus comprising:
an amplification section that amplifies power of a transmitting digital signal using predetermined amplification gain;
a conversion section that converts a post-amplification digital signal to an analog signal;
an attenuation section that attenuates power of an analog signal obtained by said conversion section to a power level of pre-amplification said digital signal; and
a determination section that determines whether or not pre-amplification said digital signal power is in a fluctuating state;
wherein said amplification section, when said determination section determines that said digital signal power is in a fluctuating state amplifies said digital signal power using fixed amplification gain, and when said determination section determines that said digital signal power is not in a fluctuating state amplifies said digital signal power using amplification gain that is in accordance with pre-amplification said digital signal power.

2. The radio transmitting apparatus according to claim 1, wherein said determination section:
further comprises a counting section that counts a number of fluctuations of pre-amplification said digital signal power in a predetermined period; and
when a counted number of fluctuations is greater than or equal to a preset threshold value, determines that said digital signal power is in a fluctuating state.

3. The radio transmitting apparatus according to claim 1, wherein said determination section determines whether or not pre-amplification said digital signal power is in a fluctuating state based on information relating to a setting of power contained in said digital signal.

4. The radio transmitting apparatus according to claim 1, wherein said determination section does not determine whether or not pre-amplification said digital signal power is in a fluctuating state when it is reported beforehand that there is no fluctuation in pre-amplification said digital signal power.

5. The radio transmitting apparatus according to claim 1, wherein said amplification section:
further comprises:
a calculation section that calculates amplification gain that is in accordance with pre-amplification said digital signal power each time pre-amplification said digital signal power is measured; and
a detection section that detects a minimum value of amplification gain calculated by said calculation section in a period in which it is determined whether or not pre-amplification said digital signal power is in a fluctuating state;
and amplifies said digital signal power using an amplification gain minimum value detected by said detection section.

6. A base station apparatus provided with the radio transmitting apparatus according to claim 1.

7. A radio transmitting method comprising:
an amplifying step of amplifying power of a transmitting digital signal using predetermined amplification gain;
a converting step of converting a post-amplification digital signal to an analog signal;
an attenuating step of attenuating power of an analog signal obtained by said converting step to a power level of pre-amplification said digital signal; and
a determining step of determining whether or not pre-amplification said digital signal power is in a fluctuating state;
wherein said amplifying step, when it is determined in said determining step that said digital signal power is in a fluctuating state amplifies said digital signal power using fixed amplification gain, and when it is determined in said determining step that said digital signal power is not in a fluctuating state amplifies said digital signal power using amplification gain that is in accordance with pre-amplification said digital signal power.

8. A radio transmitting program that causes a computer to execute:
an amplifying step of amplifying power of a transmitting digital signal using predetermined amplification gain;
a converting step of converting a post-amplification digital signal to an analog signal;
an attenuating step of attenuating power of an analog signal obtained by said converting step to a power level of pre-amplification said digital signal; and
a determining step of determining whether or not pre-amplification said digital signal power is in a fluctuating state;
wherein said amplifying step, when it is determined in said determining step that said digital signal power is in a fluctuating state amplifies said digital signal power using fixed amplification gain, and when it is determined in said determining step that said digital signal power is not in a fluctuating state amplifies said digital signal power using amplification gain that is in accordance with pre-amplification said digital signal power.
